# EUROPEAN PATENT APPLICATION

(11) **EP 4 742 877 A1**
(43) Date of publication of application: **13.05.2026**
(21) Application number: 24836123.0
(22) Date of filing: 05.07.2024
(51) Int. Cl.: H10N 30/853, H01L 21/318, H10N 30/30

(54) **DIELECTRIC ELEMENT AND METHOD FOR MANUFACTURING SAME**

(30) Priority: 06.07.2023 JP 2023111711
(71) Applicant: National Institute of Advanced Industrial Science and Technology, Chiyoda-ku Tokyo 100-8921 (JP)
(72) Inventor: HIRATA Kenji, Tsukuba-shi, Ibaraki 305-8560 (JP); AKIYAMA Morito, Tsukuba-shi, Ibaraki 305-8560 (JP); UEHARA Masato, Tsukuba-shi, Ibaraki 305-8560 (JP); TABARU Tatsuo, Tsukuba-shi, Ibaraki 305-8560 (JP); YAMADA Hiroshi, Tsukuba-shi, Ibaraki 305-8560 (JP); ANGGRAINI Sri Ayu, Tsukuba-shi, Ibaraki 305-8560 (JP)
(74) Representative: V.O.
(86) International application number: PCT/JP2024/024432
(87) International publication number: WO 2025/009611

(57) **Abstract**

This dielectric element includes a substrate, an underlayer disposed on the substrate, and a nitride thin film disposed on the underlayer, the underlayer is composed of any one element selected from rare earth elements, and the nitride thin film contains scandium, and a Group 13 element and a Group 15 element in the periodic table.

## Description

### TECHNICAL FIELD

The present invention relates to a dielectric element and a method for manufacturing the same. Priority is claimed on Japanese Patent Application No. 2023-111711, filed July 6, 2023, the content of which is incorporated herein by reference.

### BACKGROUND ART

Nitride thin films exhibiting excellent piezoelectric performances are in use in a variety of devices, for example, FBAR high pass filers for mobile communication, piezoelectric sensors, energy harvesting devices, MEMS microphones, and fingerprint authentication sensors.

In recent years, diverse and highly functional sensors have been in demand, and there has been a demand for further improvement in piezoelectric performances for nitride thin films due to the ongoing increase in frequency for communication.

For example, Patent Document 1 discloses an AlN thin film to which Sc is added, that is, a ScAlN thin film for the purpose of enhancing piezoelectric performances. At the moment, ScAlN thin films are in practical use in elastic wave filters.

### Citation List

### Patent Document

Patent Document 1: Japanese Unexamined Patent Application, First Publication No. 2019-145677

### SUMMARY OF INVENTION

### Technical Problem

For ScAlN thin films, it is known that there is a tendency that the piezoelectric constant (d₃₃) that represents the magnitude of the piezoelectric performances is maximized at a Sc concentration of 43 atom% but the piezoelectric performances deteriorate at equal or higher Sc concentrations due to the deterioration of crystallinity, the formation of a secondary phase, or the like. Incidentally, according to theoretical calculation, there is a possibility that the piezoelectric constant may improve when a higher concentration of Sc is made to form a solid solution in AIN. That is, it can be said that curbing the deterioration of crystallinity or the formation of a secondary phase leads to a technique of improving the piezoelectric performances by incorporating Sc at a high concentration. It can be considered that when it becomes possible to stably produce ScAlN thin films containing Sc at a high concentration, the production of elastic wave filters enabling transmission bands to be arbitrarily set to high frequencies far higher than several GHz levels becomes possible.

In addition, ScAlN thin films are confirmed to be ferroelectric, are highly spontaneously polarizable, and are thus expected to be applied to ferroelectric memories. However, when polarization is reversed, the applied voltages are high, and the power consumption thus becomes high at the time of applying ScAlN thin films to memories. The applied voltages can also be decreased by thinning the film thicknesses, but methods therefor are limited, and it is considered that other measures are also required. The applied voltages having a tendency of decreasing when Sc concentrations are increased have been found by experiments, and at the moment, there is a desire for the production of ScAlN thin films containing Sc at high concentrations.

Therefore, the present invention has been made in consideration of the above-described circumstances, and an object of the present invention is to provide a dielectric element that maintains ferroelectricity and has excellent piezoelectric performances and a method for manufacturing the same.

### Solution to Problem

The main points of the present invention are as described below.
[1] A dielectric element according to one aspect of the present invention including a substrate, an underlayer disposed on the substrate, and a nitride thin film disposed on the underlayer, in which the underlayer is composed of any one element selected from rare earth elements, and the nitride thin film contains scandium, and a Group 13 element and a Group 15 element in the periodic table.
[2] In the dielectric element according to [1], the nitride thin film may contain more than 43 atom% of scandium relative to a total number of atoms of the Group 13 element and scandium.
[3] In the dielectric element according to [1], the nitride thin film may contain 0 atom% or more and 43 atom% or less of scandium relative to a total number of atoms of the Group 13 element and scandium.
[4] In the dielectric element according to [1], the nitride thin film may contain 13 atom% or more and 43 atom% or less of scandium relative to a total number of atoms of the Group 13 element and scandium.
[5] In the dielectric element according to at least any of the group consisting of [1] to [4], the underlayer may have a thickness of 1180 nm or less.
[6] In the dielectric element according to at least any of the group consisting of [1] to [5], the underlayer may be composed of any of the group consisting of yttrium, lutetium, scandium, gadolinium, and cerium.
[7] In the dielectric element according to at least any of the group consisting of [1] to [6], the Group 13 element may be aluminum, and the Group 15 element may be nitrogen.
[8] The dielectric element according to at least any of the group consisting of [1] to [7] may be used in any one or more selected from the group consisting of a transistor, an inverter, a ferroelectric memory, a vibration sensor, an ultrasonic sensor, a microphone, a filter, an AI semiconductor, a power semiconductor, a piezoelectric generator, and a MEMS device.
[7] In addition, a method for manufacturing a dielectric element according to another aspect of the present invention including a step of forming an underlayer on a substrate, and a step of forming a nitride thin film on the underlayer, in which any one element selected from rare earth elements is used as a raw material of the underlayer, and scandium, and a Group 13 element and a Group 15 element in the periodic table are used as raw materials of the nitride thin film.

### Advantageous Effects of Invention

According to the present disclosure, it is possible to provide a dielectric element that maintains ferroelectricity and has excellent piezoelectric performances and a method for manufacturing the same.

### BRIEF DESCRIPTION OF DRAWINGS

[FIG. 1] A side view showing a schematic configuration of a dielectric element according to one embodiment of the present invention.
[FIG. 2] A graph between the thickness and a piezoelectric constant d₃₃ of an underlayer in Example 1.
[FIG. 3] A graph between the thickness and a dielectric tangent tan δ of the underlayer in Example 1.
[FIG. 4] A graph between the thickness and a piezoelectric constant d₃₃ of an underlayer in Example 2.
[FIG. 5] A graph between the thickness and a dielectric tangent tan δ of the underlayer in Example 2.
[FIG. 6] A graph showing an increase rate of a piezoelectric constant d₃₃ of a dielectric element having an underlayer of each element with respect to a piezoelectric constant d₃₃ of a dielectric element having no underlayer in Example 3.
[FIG. 7] A graph between a composition and a piezoelectric constant d₃₃ of a nitride thin film when Lu is used in an underlayer and a Sc concentration and an Al concentration in the nitride thin film have been changed in Example 4.

### DESCRIPTION OF EMBODIMENTS

Hereinafter, a suitable embodiment of the present invention will be described in detail with reference to the accompanying drawings.

### Dielectric Element

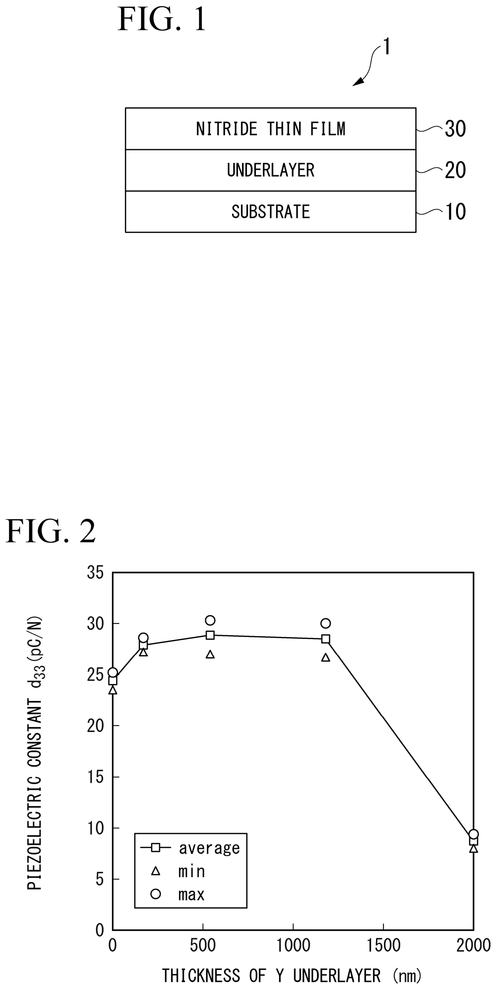

A dielectric element 1 according to one embodiment of the present invention will be described with reference to FIG. 1. The dielectric element 1 includes a substrate 10, an underlayer 20 disposed on a surface of the substrate 10, and a nitride thin film 30 disposed on a surface of the underlayer 20.

The type of the substrate 10 is not particularly limited and may be any substrate as long as the substrate enables the underlayer 20 and the nitride thin film 30, which will be described below, to be laminated thereon. The substrate 10 is composed of, for example, silicon, conductive metal, sapphire, SiC, glass, an organic material, or the like.

The underlayer 20 is composed of any one element selected from rare earth elements. The underlayer 20 is composed of any one element selected from the group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), and lutetium (Lu). Due to the fact that the underlayer 20 is composed of any one element selected from rare earth elements, the piezoelectric performances of the dielectric element 1 can be improved even in a case where the nitride thin film 30, which will be described below, contains Sc at a high concentration.

The thickness of the underlayer 20 is preferably 1180 nm or less. When the thickness of the underlayer 20 is 1180 nm or less, it is possible to increase the piezoelectric constant d₃₃. In addition, when the thickness of the underlayer 20 is 1180 nm or less, it is possible to curb dielectric losses. The thickness of the underlayer 20 may be 540 nm or less or may be 170 nm or less. In addition, the thickness of the underlayer 20 may be more than 0 nm, may be 170 nm or more, and may be 540 nm or more.

Depending on the element that configures the underlayer 20, there is a possibility that the element may be incorporated into the nitride thin film 30 to adversely affect the piezoelectric performances. However, when the element that configures the underlayer 20 is any one element selected from rare earth elements, excellent piezoelectric performances can be maintained even when the element is incorporated into the nitride thin film 30.

The nitride thin film 30 contains Sc, and a Group 13 element and a Group 15 element in the periodic table. The nitride thin film 30 is a III-V compound semiconductor and preferably a thin film in which Sc has formed a solid solution in the Group 13 element and the Group 15 element. Examples of the nitride thin film 30 include ScAlN, ScGaN, and ScInN. The nitride thin film 30 may contain a plurality of Group 13 elements or may contain a plurality of Group 15 elements.

The number of atoms of Sc (Sc concentration) relative to the total number of atoms of the Group 13 element and Sc in the nitride thin film 30 is not particularly limited. When the Sc concentration is 0 atom% or more relative to the total number of atoms of the Group 13 element and Sc, the piezoelectric constant d₃₃ of the dielectric element 1 having the above-described underlayer 20 improves. Therefore, the Sc concentration of the nitride thin film 30 is 0 atom% or more and may be more than 0 atom% or may be 13 atom% or more. Furthermore, in a case where the dielectric element 1 according to the present embodiment contains more than 43 atom% of Sc relative to the total number of atoms of the Group 13 element and Sc, it is possible to more significantly increase the piezoelectric constant. Therefore, the nitride thin film 30 preferably contains more than 43 atom% of Sc relative to the total number of atoms of the Group 13 element and Sc. The Sc concentration is more preferably 47 atom% or more and still more preferably 48 atom% or more. In addition, the Sc concentration may be, for example, 50 atom% or less, may be 48 atom% or less, may be 47 atom% or less, or may be 43 atom% or less. When the dielectric element 1 has the above-described underlayer 20, the piezoelectric constant d₃₃ improves even when the Sc concentration of the nitride thin film 30 is 43 atom% or less.

The thickness of the nitride thin film 30 can be set to, for example, 5 nm or more and 2000 nm or less. In ferroelectric memories or transistors, there is a possibility that a dielectric element having a thin film with a film thickness of approximately 10 nm may be used. When the thickness of the nitride thin film 30 is 5 nm or more, it is possible to apply the dielectric element 1 to the above-described ferroelectric memories or transistors. The thickness of the nitride thin film 30 is preferably 100 nm or more from the viewpoint of adhesion.

The nitride thin film 30 may be a single layer or a plurality of layers of nitride thin films having mutually different polarization directions.

The dielectric element 1 is applied to a variety of fields. For example, the dielectric element 1 may be used in any one or more selected from the group consisting of transistors, inverters, ferroelectric memories, vibration sensors, ultrasonic sensors, microphones, filters, AI semiconductors, power semiconductors, piezoelectric generators, and MEMS devices (including piezoelectric devices). The filters include, for example, FBAR high pass filers for mobile communication and the like. The microphones include, for example, MEMS microphones and the like. In addition, the dielectric element 1 may also be used in piezoelectric sensors, energy harvesting devices, fingerprint authentication sensors, and the like.

### Method for Manufacturing Dielectric Element

A manufacturing method is not particularly limited and may be any manufacturing method as long as the above-described dielectric element 1 can be obtained by the manufacturing method. One example of the method for manufacturing a dielectric element includes a step of forming an underlayer on a substrate, and a step of forming a nitride thin film on the underlayer. Any one element selected from rare earth elements is used as a raw material of the underlayer, and scandium, and a Group 13 element and a Group 15 element in the periodic table are used as raw materials of the nitride thin film. The underlayer and the nitride thin film are formed by, for example, a sputtering method.

Hitherto, the suitable embodiment of the present invention has been described in detail with reference to the accompanying drawings, but the present invention is not limited to such examples. It is obvious that any person skilled in the art to which the present invention pertains can come to an idea of a variety of modification examples or correction examples within the scope of the technical concept described in claims, and it is needless to say that these are also understood to belong to the technical scope of the present invention.

### Examples

The effect of one aspect of the present invention will be specifically described with examples. Here, conditions in the examples are simply examples of conditions adopted to confirm the feasibility and effect of the present invention. The present invention is not limited to these examples of conditions. The present invention can be adopted under a variety of conditions without departing from the gist of the present invention as long as the object of the present invention is achieved.

### Example 1

An underlayer of Y was formed on a Si (100) substrate having an area of 1 × 1 square inch, and a nitride thin film of ScAlN was then formed on the underlayer to produce a dielectric element. In addition, a nitride thin film of ScAlN was formed on a Si (100) substrate having an area of 1 × 1 square inch without forming an underlayer on the substrate to produce a dielectric element. The underlayers and the nitride thin films were each formed by a sputtering method under the following conditions. A sputtering apparatus L-332S-FH manufactured by Canon Anelva Corporation was used as a sputtering apparatus.

In the formation of the underlayer, Y was used as a sputtering target. An Ar atmosphere was used as the atmosphere, and the atmospheric pressure at the time of sputtering was set to 0.2 Pa. The substrate temperature was set to 250°C. The underlayer formation time was set to five minutes, 15 minutes, 30 minutes, and 60 minutes, and underlayers having thicknesses of 170 nm, 540 nm, 1180 nm, and 2000 nm, respectively, were formed.

The thickness of the underlayer was calculated by the following method. That is, a sample in which only the underlayer had been formed was produced, and a region in which a thin film had been formed and a region in which a thin film was not formed were provided. In addition, the interface therebetween (level difference) was measured with a surface roughness measuring machine (SURFCOM1800G, manufactured by Tokyo Seimitsu Co., Ltd.), thereby estimating the film thickness.

In the formation of the nitride thin film, an Al-Sc alloy (50 atom% of Sc) was used as a sputtering target. An Ar-N₂ mixed atmosphere was used as the atmosphere, and Ar:N₂ was set to 6.2:3.8. The atmospheric pressure at the time of sputtering was set to 0.3 Pa. The substrate temperature was set to 350°C. The underlayer formation time was set to three hours.

The proportion of Sc (Sc concentration) in the total number of atoms of Al and Sc in the nitride thin film was measured by the following method. That is, the Sc concentrations were measured at five or more places in each sample using an EDX apparatus (Energy Dispersive X-ray spectroscope, EX-420 manufactured by Horiba, Ltd.) in a scanning electron microscope (S-4300 manufactured by Hitachi High-Tech Corporation) with an accelerating voltage set to 15 kV, and the average value thereof was adopted. As a result, the Sc concentrations of the nitride thin films in all of the dielectric elements were 47 atom%.

The piezoelectric constant d₃₃ of each dielectric element was measured by the following method. That is, aluminum was vapor-deposited on the surfaces of the dielectric element to form electrodes, the dielectric element was sandwiched between the individual electrodes and held with two probes, and the piezoelectric constant d₃₃ was measured using a PiezoMeter (PM300, manufactured by Piezotest Ltd.). The piezoelectric constants d₃₃ were measured at three places in each dielectric element, and the maximum value, the minimum value, and the average value were calculated. Measuring points were vertically and horizontally positioned at equal intervals.

The dielectric tangent tan δ of each dielectric element was measured by the following method. That is, the dielectric tangent tan δ was measured using a PiezoMeter (PM300, manufactured by Piezotest Ltd.). The dielectric tangents tan δ were measured at three places in each dielectric element, and the maximum value, the minimum value, and the average value were calculated. Measuring points were vertically and horizontally positioned at equal intervals. The dielectric tangent tan δ represents the degree of an electric energy loss in a dielectric body, and it can be considered that the performance of the dielectric body becomes higher as the dielectric tangent tan δ becomes lower.

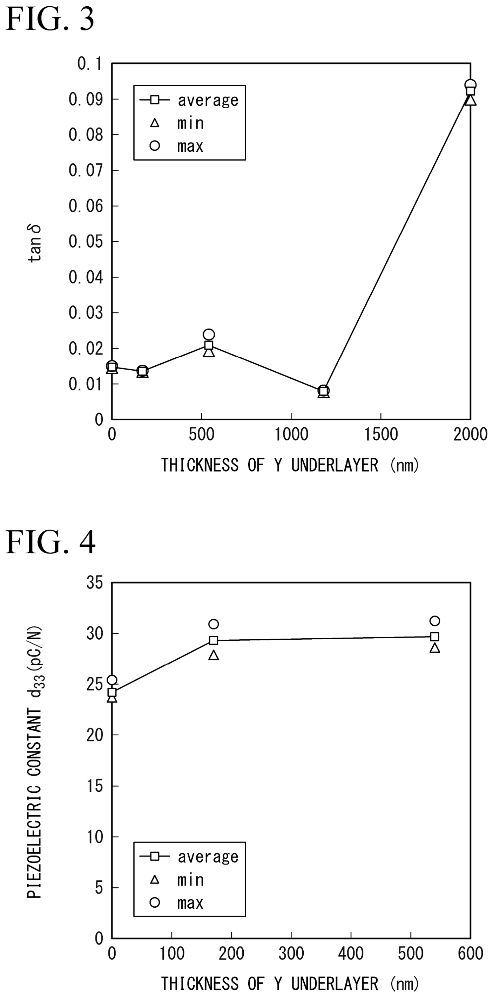

Table 1 shows the average value, minimum value, and maximum value of the piezoelectric constants d₃₃ for each thickness of the underlayer. Table 2 shows the average value, minimum value, and maximum value of the dielectric tangent tan δ for each thickness of the underlayer. FIG. 2 shows a graph between the thickness and piezoelectric constant d₃₃ of the underlayer, and FIG. 3 shows a graph between the thickness and dielectric tangent tan δ of the underlayer.

**[Table 1]**

| Thickness of Y underlayer (nm) | Piezoelectric constant d₃₃ (pC/N) | | |
|---|---|---|---|
| | Average value | Minimum value | Maximum value |
| 0 | 24.4 | 23.5 | 25.2 |
| 170 | 27.9 | 27.2 | 28.6 |
| 540 | 28.9 | 27.0 | 30.3 |
| 1180 | 28.5 | 26.7 | 30.0 |
| 2000 | 8.7 | 8.0 | 9.4 |

**[Table 2]**

| Thickness of Y underlayer (nm) | tan δ | | |
|---|---|---|---|
| | Average value | Minimum value | Maximum value |
| 0 | 0.0147 | 0.0145 | 0.0150 |
| 170 | 0.0136 | 0.0134 | 0.0137 |
| 540 | 0.0209 | 0.0192 | 0.0239 |
| 1180 | 0.0079 | 0.0077 | 0.0082 |
| 2000 | 0.0923 | 0.0899 | 0.0940 |

As shown in Table 1 and FIG. 2, in a case where the thicknesses of the underlayers of Y were 170 nm or more and 1180 nm or less, the dielectric constants became large compared with those of the dielectric elements with no underlayer (the thickness of the underlayer was zero). In detail, the average value of the piezoelectric constants d₃₃ of the dielectric elements with no underlayer was 24.4 pC/N; however, when the underlayer of Y having a thickness of 540 nm was provided, the average value of the piezoelectric constants d₃₃ reached 28.9 pC/N, and the maximum value reached 30.3 pC/N.

In addition, as shown in Table 2 and FIG. 3, in a case where the thicknesses of the underlayers of Y were 170 nm or more and 1180 nm or less, the dielectric tangents were approximately the same as those of the dielectric elements with no underlayer. In detail, the average value of the dielectric tangents tan δ of the dielectric elements with no underlayer was 0.0147; however, when the underlayer of Y having a thickness of 1180 nm was provided, the average value of the dielectric tangent tan δ reached 0.0079.

### Example 2

An underlayer of Y was formed on a Si (100) substrate having an area of 1 × 1 square inch, and a nitride thin film of ScAlN was then formed on the underlayer to produce a dielectric element. The underlayer was formed by the same method as in Example 1.

In the formation of the underlayer, Y was used as a sputtering target. An Ar atmosphere was used as the atmosphere, and the atmospheric pressure at the time of sputtering was set to 0.2 Pa. The substrate temperature was set to 250°C. The underlayer formation time was set to five minutes and 15 minutes, and underlayers having thicknesses of 170 nm and 540 nm, respectively, were formed.

In the formation of the nitride thin film, an Al-Sc alloy (50 atom% of Sc) was used as a sputtering target. An Ar-N₂ mixed atmosphere was used as the atmosphere, and Ar:N₂ was set to 6.2:3.8. The atmospheric pressure at the time of sputtering was set to 0.3 Pa. The substrate temperature was set to 350°C. The underlayer formation time was set to three hours.

The Sc concentrations of the produced nitride thin films were measured by the same method as in Example 1, and the Sc concentrations of the individual nitride thin films were all 48 atom%.

The piezoelectric constant d₃₃ and dielectric tangent tan δ of each dielectric element were measured by the same methods as in Example 1.

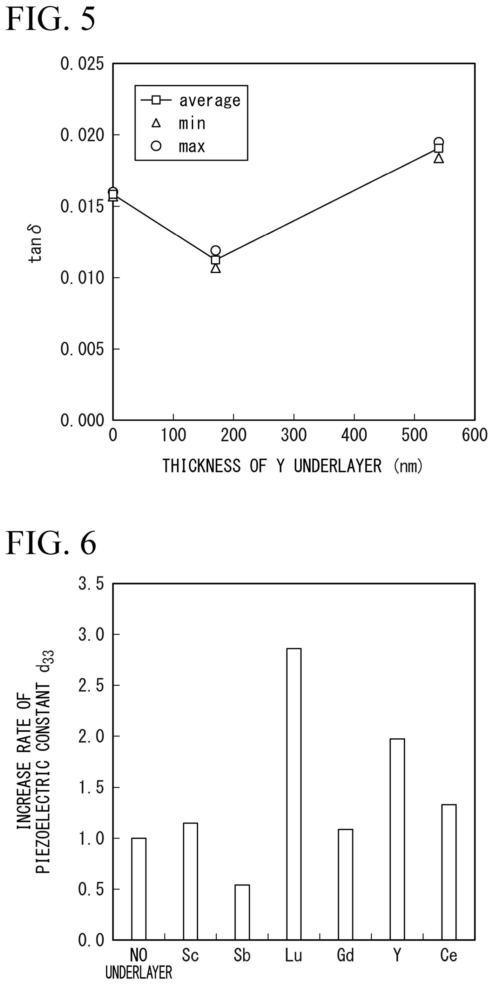

Table 3 shows the average value, minimum value, and maximum value of the piezoelectric constants d₃₃ for each thickness of the underlayer. Table 4 shows the average value, minimum value, and maximum value of the dielectric tangent tan δ for each thickness of the underlayer. In addition, FIG. 4 shows a graph between the thickness and piezoelectric constant d₃₃ of the underlayer, and FIG. 5 shows a graph between the thickness and dielectric tangent tan δ of the underlayer.

**[Table 3]**

| Thickness of Y underlayer (nm) | Piezoelectric constant d₃₃ (pC/N) | | |
|---|---|---|---|
| | Average value | Minimum value | Maximum value |
| 0 | 24.2 | 23.7 | 25.4 |
| 170 | 29.3 | 27.9 | 30.9 |
| 540 | 29.7 | 28.6 | 31.2 |

**[Table 4]**

| Thickness of Y underlayer (nm) | tan δ | | |
|---|---|---|---|
| | Average value | Minimum value | Maximum value |
| 0 | 0.0158 | 0.0157 | 0.0160 |
| 170 | 0.0112 | 0.0107 | 0.0119 |
| 540 | 0.0191 | 0.0184 | 0.0195 |

As shown in Table 3 and FIG. 4, in a case where the thicknesses of the underlayers of Y were 170 nm and 540 nm, the dielectric constants became large compared with those of the dielectric elements with no underlayer (the thickness of the underlayer was zero). In addition, as shown in Table 4 and FIG. 5, in a case where the thicknesses of the underlayers of Y were 170 nm and 540 nm, the dielectric tangents were approximately the same as those of the dielectric elements with no underlayer.

### Example 3

A plurality of Si (100) substrates having an area of 17 × 17 square millimeters were prepared, an underlayer of Sc, Lu, Gd, Y, Ce, or Sb (antimony) was formed on each substrate, and a nitride thin film of ScAlN was then formed on each underlayer to produce a dielectric element. In addition, a dielectric element was produced by forming a nitride thin film of ScAlN on a Si (100) substrate having an area of 17 × 17 square millimeters without forming an underlayer.

In the formation of the underlayer, a sputtering target of each of the above-described elements was used. An Ar atmosphere was used as the atmosphere, and the atmospheric pressure at the time of sputtering was set to 0.2 Pa. The substrate temperature was set to 250°C. The underlayer formation time was set to 10 minutes, and underlayers having thicknesses shown in Table 5 were formed.

In the formation of the nitride thin film, an Al-Sc alloy (55 atom% of Sc) was used as a sputtering target. An Ar-N₂ mixed atmosphere was used as the atmosphere, and Ar:N₂ was set to 4:6. The atmospheric pressure at the time of sputtering was set to 0.6 Pa. The substrate temperature was set to 400°C. The underlayer formation time was set to three hours.

The Sc concentrations of the produced nitride thin films were measured by the same method as in Example 1. Table 5 shows the Sc concentrations of the nitride thin films.

The piezoelectric constant d₃₃ was measured using PiezoMeter (PM300, manufactured by Piezotest Ltd.) with the dielectric element sandwiched and held between two probes from the front surface and rear surface of each dielectric element. In the present example, the piezoelectric constant d₃₃ was measured without forming an electrode in order to prevent the occurrence of a short-circuit due to an electrode metal being inserted into pores in the thin film, which makes it impossible to measure the piezoelectric constant.

Table 5 and FIG. 6 show the increase rate of the piezoelectric constant d₃₃ of the dielectric element having each underlayer with respect to the piezoelectric constant d₃₃ of the dielectric element having no underlayer. In other words, the piezoelectric constant d₃₃ of each dielectric element when the piezoelectric constant d₃₃ of the dielectric element having no underlayer was regarded as one is shown in Table 5 and FIG. 6.

**[Table 5]**

| Presence or absence of underlayer | Film thickness of underlayer (nm) | Sc concentration of nitride thin film (atom%) | Increase rate of piezoelectric constant d₃₃ |
|---|---|---|---|
| No underlayer | - | 50.3 | 1 |
| Sc | Less than 100 | 56.4 | 1.15 |
| Sb | Less than 100 | 50.4 | 0.54 |
| Lu | 300 | 54.4 | 2.86 |
| Gd | 350 | 51.2 | 1.09 |
| Y | 150 | 50.6 | 1.97 |
| Ce | 120 | 51.0 | 1.33 |

As shown in Table 5 and FIG. 6, the piezoelectric constants of the dielectric elements for which the element that configures the underlayer was Sc, Lu, Gd, Y, or Ce were larger than the piezoelectric constant of the dielectric element having no underlayer. On the other hand, the piezoelectric constant of the dielectric element in which not rare earth elements but Sb was used for the underlayer was smaller than the piezoelectric constant of the dielectric element having no underlayer.

### Example 4

Underlayers of Lu were formed on Si (100) substrates having an area of 17 × 17 square millimeters, and nitride thin films of ScₓAl₁₋ₓN for which the Sc concentration and the Al concentration were changed were then formed on the underlayers to produce a plurality of dielectric elements in which the nitride thin films had different compositions. Specifically, nitride thin films having compositions of AIN, Sc_{0.13}Al_{0.87}N, Sc_{0.41}Al_{0.59}N, Sc_{0.47}Al_{0.53}N, and Sc_{0.50}Al_{0.50}N were formed. The underlayers were formed by the same method as in Example 1. In addition, a dielectric element in which no underlayer was provided and a nitride thin film of ScₓAl₁₋ₓN was formed on a substrate was produced.

In the formation of the underlayer, Lu was used as a sputtering target. An Ar atmosphere was used as the atmosphere, and the atmospheric pressure at the time of sputtering was set to 0.4 Pa. The substrate temperature was set to 400°C. The underlayer formation time was set to six minutes, and the underlayers were formed.

The compositions of the nitride thin films were adjusted by changing the composition of an Al-Sc alloy, which was used as the sputtering target. An Ar-N₂ mixed atmosphere was used as the atmosphere, and Ar:N₂ was set to 7:3. The atmospheric pressure at the time of sputtering was set to 0.8 Pa. The substrate temperature was set to 400°C. The underlayer formation time was set to three hours.

The proportion of Sc in the total number of atoms of Al and Sc in each nitride thin film was measured by the same method as in Example 1. In addition, the piezoelectric constant d₃₃ of each dielectric element was measured by the same method as in Example 1.

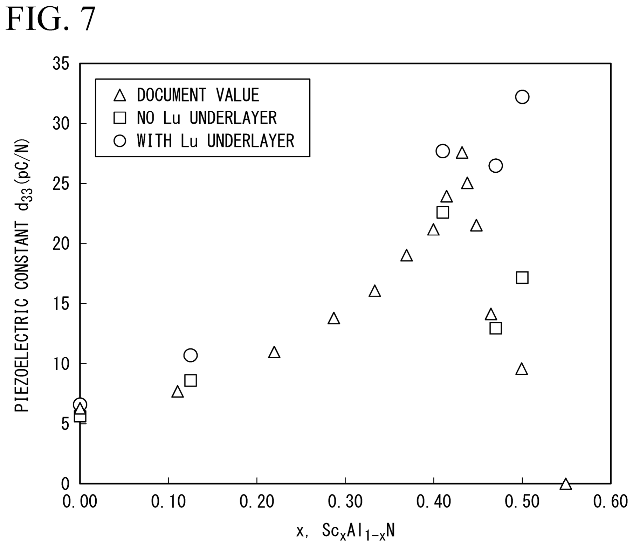

Table 6 and FIG. 7 show a graph between the compositions and piezoelectric constants d₃₃ of the nitride thin films when Lu was used in the underlayers and the Sc concentrations and the Al concentrations in the nitride thin films had been changed. In FIG. 7, piezoelectric constants d₃₃ described in M. Akiyama, K. Kano, A. Teshigahara, Appl. Phys. Lett. 95, 162107 (2009) are shown as "document values" as references. The piezoelectric constants d₃₃ described in the document are the piezoelectric constants d₃₃ of ScₓAl₁₋ₓN thin films formed with different Sc concentrations x at a substrate temperature of 400°C and are shown in FIG. 1(b) in the document. For example, the piezoelectric constant d₃₃ is 27.6 pC/N when the Sc concentration (x) is 0.43.

**[Table 6]**

| ScₓAl₁₋ₓN | d₃₃ (pC/N) | |
|---|---|---|
| x | No underlayer | With Lu underlayer |
| 0.00 | 5.6 | 6.6 |
| 0.13 | 8.6 | 10.7 |
| 0.41 | 22.6 | 27.7 |
| 0.47 | 13.0 | 26.5 |
| 0.50 | 17.2 | 32.2 |

As shown in Table 6 and FIG. 7, it was found that the piezoelectric constants d₃₃ of the dielectric elements having the underlayer of Lu were large compared with the piezoelectric constant d₃₃ of the dielectric element having no underlayer.

### REFERENCE SIGNS LIST

1 Dielectric element
10 Substrate
20 Underlayer
30 Nitride thin film

## Claims

1. A dielectric element comprising:
a substrate;
an underlayer disposed on the substrate; and
a nitride thin film disposed on the underlayer,
wherein the underlayer is composed of any one element selected from rare earth elements, and
the nitride thin film contains scandium, and a Group 13 element and a Group 15 element in the periodic table.

2. The dielectric element according to Claim 1,
wherein the nitride thin film contains more than 43 atom% of scandium relative to a total number of atoms of the Group 13 element and scandium.

3. The dielectric element according to Claim 1,
wherein the nitride thin film contains 0 atom% or more and 43 atom% or less of scandium relative to a total number of atoms of the Group 13 element and scandium.

4. The dielectric element according to Claim 1,
wherein the nitride thin film contains 13 atom% or more and 43 atom% or less of scandium relative to a total number of atoms of the Group 13 element and scandium.

5. The dielectric element according to any one of Claims 1 to 4,
wherein the underlayer has a thickness of 1180 nm or less.

6. The dielectric element according to any one of Claim 1 to 4,
wherein the underlayer is composed of any of the group consisting of yttrium, lutetium, scandium, gadolinium, and cerium.

7. The dielectric element according to Claim 5,
wherein the underlayer is composed of any of the group consisting of yttrium, lutetium, scandium, gadolinium, and cerium.

8. The dielectric element according to any one of Claims 1 to 4,
wherein the Group 13 element is aluminum, and the Group 15 element is nitrogen.

9. The dielectric element according to Claim 5,
wherein the Group 13 element is aluminum, and the Group 15 element is nitrogen.

10. The dielectric element according to Claim 6,
wherein the Group 13 element is aluminum, and the Group 15 element is nitrogen.

11. The dielectric element according to Claim 7,
wherein the Group 13 element is aluminum, and the Group 15 element is nitrogen.

12. The dielectric element according to any one of Claim 1 to 4 that is used in any one or more selected from the group consisting of a transistor, an inverter, a ferroelectric memory, a vibration sensor, an ultrasonic sensor, a microphone, a filter, an AI semiconductor, a power semiconductor, a piezoelectric generator, and a MEMS device.

13. A method for manufacturing a dielectric element, the method comprising:
a step of forming an underlayer on a substrate; and
a step of forming a nitride thin film on the underlayer,
wherein any one element selected from rare earth elements is used as a raw material of the underlayer, and
scandium, and a Group 13 element and a Group 15 element in the periodic table are used as raw materials of the nitride thin film.
